# EUROPÄISCHE PATENTSCHRIFT

(11) **EP 3 005 564 B1**
(45) Veröffentlichungstag und Bekanntmachung des Hinweises auf die Patenterteilung: **31.10.2018**
(21) Anmeldenummer: 14725696.0
(22) Anmeldetag: 22.05.2014
(51) Int. Cl.: H03K 17/945, G06F 3/01, G06F 3/03, H03K 17/94

(54) **SCHALTERBETÄTIGUNGSEINRICHTUNG, MOBILES GERÄT UND VERFAHREN ZUM BETÄTIGEN EINES SCHALTERS DURCH EINE NICHT-TAKTILE TRANSLATIONSGESTE**
SWITCH ACTUATION SYSTEM, MOBILE DEVICE AND METHOD FOR ACTUATING A SWITCH USING A NON-TACTILE TRANSLATIONAL GESTURE
DISPOSITIF D'ACTIONNEMENT DE COMMUTATEUR, APPAREIL MOBILE ET PROCÉDÉ POUR ACTIONNER UN COMMUTATEUR PAR UN GESTE DE TRANSLATION NON TACTILE

(30) Priorität: 24.05.2013 US 201361827108 P
(43) Veröffentlichungstag der Anmeldung: 13.04.2016
(73) Patentinhaber: Pyreos Ltd., Edinburgh EH9 3JF (GB)
(72) Erfinder: GIEBELER, Carsten, Edinburgh EH32 0PE (GB); BROWN, Spyros, Edinburgh EH11 2LJ (GB); CHAMBERLAIN, Tim, Edinburgh Eh5 2ad (GB); HURWITZ, Jonathan Ephraim David, Edinburgh EH6 7PJ (GB)
(74) Vertreter: Leach, James
(86) Internationale Anmeldenummer: PCT/EP2014/060546
(87) Internationale Veröffentlichungsnummer: WO 2014/187900

(56) Entgegenhaltungen:
- WO-A1-93/09414
- WO-A1-2011/018253
- DE-A1-102009 017 845
- JP-A- 2008 232 715
- US-A1- 2010 204 953
- US-A1- 2010 295 773
- US-A1- 2011 050 643

## Beschreibung

Die Erfindung betrifft eine Schalterbetätigungseinrichtung, ein mobiles Gerät mit der Schalterbetätigungseinrichtung und ein Verfahren zur Betätigung eines Schalters mit der Schalterbetätigungseinrichtung durch eine nicht-taktile Translationsgeste, insbesondere einer menschlichen Hand.

Zur Mensch-Computer-Interaktion sind interaktive Systeme und deren Mensch-Maschine-Schnittstellen bekannt, die mit einer Einrichtung zur automatischen Erkennung von durch Menschen ausgeführten nicht-taktilen oder taktilen Gesten ausgestattet sind. Die Geste kann prinzipiell von jeder Körperhaltung und jeder Körperbewegung abgeleitet werden, wobei die größte Bedeutung Handgesten haben. Die Gestenerkennungseinrichtung ist mit einem Gerät zur optischen Erfassung insbesondere der gestikulierenden Hand ausgestattet, wobei die dadurch erzeugten Bildinformationen mit entsprechenden Algorithmen ausgewertet werden, um eine Geste aus den Bildinformationen abzuleiten. Das Gerät zur optischen Erfassung einer nicht-taktilen Geste ist herkömmlich eine Kamera, die nachteilig einen großen Bauraum einnimmt und hohe Investitionskosten mit sich bringt. Dadurch sind kamerabasierte Einrichtungen zur Gestenerkennung in miniaturisierter Bauweise bei günstigen Kosten, wie es etwa für die Anwendung in Mobiltelefonen vorteilhaft wäre, nicht zu realisieren. Außerdem haben kamerabasierte Einrichtungen nachteilig einen hohen Energieverbrauch, wodurch mobile Anwendungen nur schwer umzusetzen sind. Alternativ sind Hochgeschwindigkeitsspektrometer bekannt, die hinsichtlich der miniaturisierten Bauweise bei geringen Kosten keine Abhilfe schaffen können. Außerdem sind Berührungsbildschirme für insbesondere Mobiltelefone bekannt, jedoch sind die Berührbildschirme nur für die Erkennung von taktilen Gesten und nicht für die Erkennung von nicht-taktilen Gesten geeignet.

US2010/204953 hingegen offenbart eine Vorrichtung zur Gestenerkennung mit pyroelektrischen Sensoren, bei der die Ausgangssignale von jeweils zwei Sensoren kombiniert werden, um dann anhand von zwei Signalen aus insgesamt vier Sensoren eine von vier Bewegungsgesten zu ermitteln.

Aufgabe der Erfindung ist es eine Schalterbetätigungseinrichtung, ein mobiles Gerät mit der Schalterbetätigungseinrichtung und ein Verfahren zur Betätigung eines Schalters mit der Schalterbetätigungseinrichtung durch eine nicht-taktile Translationsgeste zu schaffen, wobei die Schalterbetätigungseinrichtung eine miniaturisierte Bauweise bei günstigen Kosten und geringem Energieverbrauch hat und die Betätigung des Schalters mit der Schalterbetätigungseinrichtung sicher und fehlerarm ist.

Die Aufgabe wird gelöst mit den Merkmalen der Patentansprüche 1, 6 und 7. Bevorzugte Ausgestaltungen dazu sind in den weiteren Patentansprüchen angegeben.

Die erfindungsgemäße Schaltbetätigungseinrichtung zum Betätigen eines Schalters durch vier mögliche Arten von nicht-taktilen Translationsgesten, die mit einem Wärme emittierenden Teil auszuüben sind, weist einen Gestensensor, der eingerichtet ist beim Ausüben einer der Arten der Translationsgesten vom Teil emittierte Wärme mittels vier nebeneinander angeordneter Pixel zu detektieren und pro Pixel, die jeweils einen Dünnfilm aus pyroelektrischem Material aufweisen, ein Signal mit einem Signalausschlag entsprechend dem zeitlichen Intensitätsverlauf der vom Dünnfilm des entsprechenden Pixels detektierten Wärme auszugeben, eine Signalauswerteeinheit, mit der aus dem zeitlichen Aufeinanderfolgen der Signalausschläge die Ausübung einer der Arten der Translationsgesten ermittelbar ist, und einen Aktuator aufweist, der von der Signalauswerteeinheit angesteuert und, sobald die Ausübung einer der Arten der Translationsgesten ermittelt ist, den Schalter betätigt, wobei eine erste Art der Translationsgesten durch eine Bewegung des Teils in eine Längsrichtung, eine zweite Art der Translationsgesten durch eine Bewegung des Teils entgegen der Längsrichtung, eine dritte Art der Translationsgesten durch eine Bewegung des Teils in eine von der Längsrichtung abweichende Querrichtung und eine vierte Art der Translationsgesten durch eine Bewegung des Teils entgegen der Querrichtung definiert ist und vier der Pixel jeweils in einer der Ecken eines konvexen Vierecks angeordnet sind, dessen eine der Diagonalen im Wesentlichen parallel zur Längsrichtung und die andere Diagonale im Wesentlichen parallel zur Querrichtung sind.

Das erfindungsgemäße mobile Gerät weist die Schalterbetätigungseinrichtung auf, wobei der Schalter zum Aktivieren/Deaktivieren einer Funktionalität des mobilen Geräts in diesem verschaltet ist.

Das erfindungsgemäße Verfahren zum Betreiben der Schalterbetätigungseinrichtung weist die Schritte auf: Ausüben einer Art der möglichen Translationsgesten mit dem Wärme emittierenden Teil, so dass von den Pixel die Aufeinanderfolge der Signalausschläge an die Signalauswerteeinheit ausgegeben wird; anhand der Aufeinanderfolge der Signalausschläge: Identifizieren des zuerst angesprochenen Pixels und des zuletzt angesprochenen Pixels; Überprüfen, ob die Signalausschläge der beiden anderen Pixel zeitlich zwischen den Signalausschlägen des zuerst angesprochenen Pixels und des zuletzt angesprochenen Pixels liegen; ist die Überprüfung positiv, Fortfahren mit dem nächsten Schritt; Zuordnen der vom zuerst angesprochenen Pixel und zuletzt angesprochenen Pixel gebildeten Diagonale zur Längsrichtung oder zur Querrichtung, je nachdem zu welcher Richtung die Diagonale paralleler ist, und Berücksichtigen der Ansprechreihenfolge vom zuerst angesprochenen Pixel und zuletzt angesprochenen Pixel, so dass die Art der ausgeübten Translationsgeste als die erste, die zweite, die dritte oder die vierte Art identifiziert wird; je nach identifizierter Art der Translationsgeste: entsprechendes Ansteuern des Aktuators zum Betätigen des Schalters durch die Signalauswerteeinheit. Bevorzugt ist das pyroelektrische Material Bleizirkonattitanat.

Dadurch, dass die Pixel jeweils den Dünnfilm aus dem pyroelektrischem Material, bevorzugt Bleizirkonattitanat, aufweisen, sind die Signale, die vom Wärme emittierenden Teil beim Ausüben von den nicht-taktilen Translationsgesten erzeugt werden, derart vorteilhaft beschaffen, dass die Erkennung der Art der ausgeübten Translationsgeste mit dem erfindungsgemäßen Verfahren sicher und fehlerarm durchführbar ist. Außerdem ist der Gestensensor mit den Pixel derart in einer miniaturisierten Bauweise bei günstigen Kosten herstellbar, dass die Schalterbetätigungseinrichtung für das mobile Gerät vorteilhaft einsetzbar ist. Das Signal wird mit den Dünnfilmen durch die von dem Teil emittierte Wärme erzeugt, so dass der Gestensensor mit einer externen Energiequelle nicht mit Energie versorgt zu werden braucht. Somit weist die Schalterbetätigungseinrichtung die Signalauswerteeinheit und den Aktuator als Energieverbraucher auf, so dass insgesamt der Energieverbrauch der Schalterbetätigungseinrichtung für das mobile Gerät vorteilhaft niedrig ist.

Bevorzugtermaßen ist das Viereck ein Rhombus. Der Abstand von zwei unmittelbar benachbarten Pixeln beträgt bevorzugt zwischen 50 µm bis 300 µm. Außerdem ist es bevorzugt, dass das Teil eine menschliche Hand und die vom Teil emittierte Wärme die von der menschlichen Hand abgestrahlte Körperwärme ist. Mit den bevorzugten Ausgestaltungen der Schalterbetätigungseinrichtung ist die Erkennung der Art der ausgeübten nicht-taktilen Translationsgeste mit der menschlichen Hand im Rahmen üblicher menschlicher Bewegungsabläufe besonders sicher und fehlerarm ermöglicht.

Bevorzugt weist das Verfahren zum Betreiben der Schalterbetätigungseinrichtung den Schritt auf: Überprüfen, ob die Absolutwerte aller vier Signalausschläge über einem vorherbestimmten Niveau liegen; ist die Überprüfung positiv, Fortfahren mit dem nächsten Schritt. Dadurch wird vorteilhaft erreicht, dass Störsignale, die etwa durch Einflüsse aus der Umgebung von den Pixeln abgegeben werden, die Gestenauswertung nicht beeinträchtigen, wodurch die Genauigkeit der Gestenerkennung erhöht ist.

Ferner ist es bevorzugt, dass das Verfahren zum Betreiben der Schalterbetätigungseinrichtung den Schritt aufweist: Überprüfen, ob der zeitliche Versatz derjenigen Signalausschläge, die zeitlich zwischen den Signalausschlägen des zuerst angesprochenen Pixels und des zuletzt angesprochenen Pixels liegen, innerhalb einer ersten vorherbestimmten Versatzzeitspanne liegt; ist die Überprüfung positiv, Fortfahren mit dem nächsten Schritt. Besonders bevorzugt ist es, dass die erste vorherbestimmte Versatzzeitspanne 0,5 ms beträgt. Somit sollen die mittleren Signalausschläge, die zeitlich nach dem ersten Signalausschlag und zeitlich vor dem letzten Signalausschlag auftreten, innerhalb der Versatzzeitspanne von 0,5 ms auftreten, wodurch der Grad der Gleichzeitigkeit des Auftretens der mittleren Signalausschläge für die sichere und fehlerfreie Gestenerkennung festgelegt ist.

Das Verfahren zum Betreiben der Schalterbetätigungseinrichtung weist bevorzugtermaßen ferner den Schritt auf: Überprüfen, ob der zeitlich erste Signalausschlag mindestens um eine zweite vorherbestimmte Versatzzeitspanne vor dem zeitlichen zweiten oder dritten Signalausschlag und der zeitlich vierte Signalausschlag mindestens um die zweite vorherbestimmte Versatzzeitspanne nach dem zeitlich zweiten oder dritten Signalausschlag liegen; ist die Überprüfung positiv, Fortfahren mit dem nächsten Schritt. Besonders bevorzugt ist es, dass die zweite vorherbestimmte Versatzzeitspanne zwischen 7 ms und 40 ms liegt. Durch die zweite vorherbestimme Versatzzeitspanne wird der zeitliche Vorlauf des ersten Signalausschlags und der zeitliche Nachlauf des letzten Signalausschlags bezogen auf die mittleren Signalausschläge für die sichere und fehlerfreie Gestenerkennung festgelegt.

Das Überprüfen, ob der zeitliche Versatz der mittleren Signalausschläge innerhalb der ersten vorherbestimmten Versatzzeitspanne liegt und ob der zeitliche Vorlauf des ersten Signalausschlags und der zeitliche Nachlauf des letzten Signalausschlags bezogen auf die mittleren Signalausschläge jeweils innerhalb der zweiten vorherbestimmten Versatzzeitspanne liegen, ermöglicht die Auswertung der Richtung der nicht-taktilen Translationsgeste. Sind eine der Überprüfungen oder beide Überprüfungen positiv, kann sicher und fehlerarm die Art der ausgeübten Translationsgeste ermittelt werden, nämlich, ob die ausgeübte Translationsgeste die erste, die zweite, die dritte oder die vierte Art hat. Ist jedoch eine der Überprüfungen oder sind beide Überprüfungen negativ, wurde die Translationsgeste nicht in der dafür vorgesehenen Richtungen ausgeübt, wodurch diese Translationsgeste nicht als eine der vier Arten identifiziert werden kann und somit verworfen wird. Die für die Translationsgesten vorgesehenen Richtungen sind im Wesentlichen parallel zur Längsrichtung oder im Wesentlichen parallel zur Querrichtung.

Bevorzugt ist es, dass für die Signalausschläge entweder die Amplitudenverläufe der von den Pixel ausgegebenen Signale oder die erste Ableitung nach der Zeit der Amplitudenverläufe der von den Pixel ausgegebenen Signale verwendet werden. Insbesondere bei der Verwendung der Ableitung nach der Zeit der Amplitudenverläufe wird überraschenderweise beobachtet, dass eine noch schärfere und fehlertolerantere Erkennung der Arten der Translationsgesten ermöglicht ist, wodurch die Gestenerkennung mit der erfindungsgemäßen Schalterbetätigungseinrichtung und dem erfindungsgemäßen Verfahren zum Betreiben der Schalterbetätigungseinrichtung noch sicherer und fehlerärmer ist.

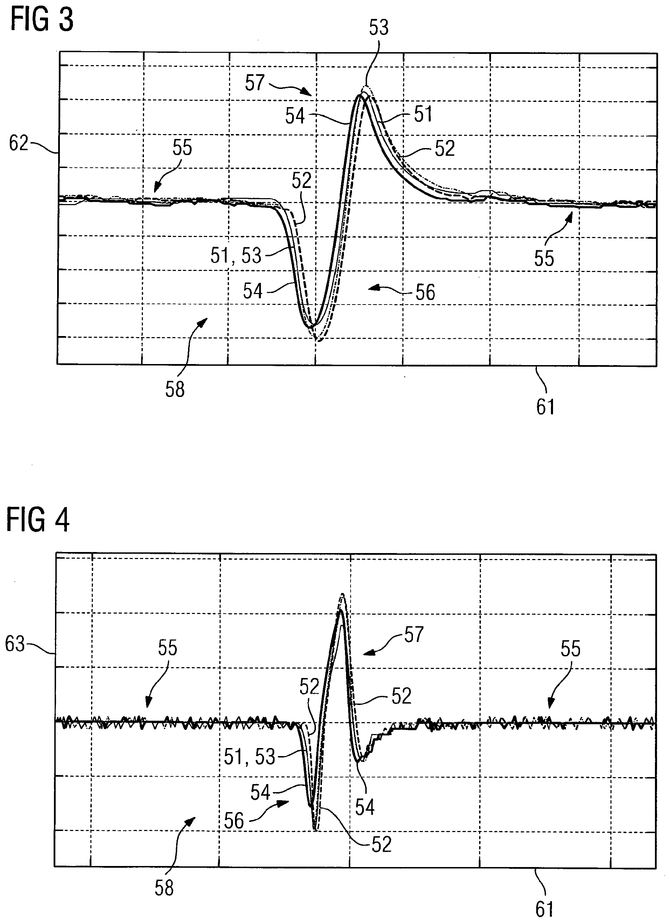

Erfindungsgemäß weisen die Pixel jeweils die Dünnschicht aus dem pyroelektrischen Material, bevorzugt Bleizirkonattitanat, auf. Dadurch geht mit dem durch das Annähern des Teils an jedes der Pixel und das Entfernen des Teils von jedem der Pixel der jeweilige Signalausschlag in S-Form einher, der eine Sinusform hat, wie es insbesondere in Figur 3 gezeigt ist. Bevorzugtermaßen weist das Verfahren zum Betreiben der Schalterbetätigungseinrichtung den Schritt auf: Identifizieren der Formen der Signalausschläge und Überprüfen, ob die Formen der Signalausschläge jeweils die S-Form haben; ist die Überprüfung positiv, Fortfahren mit dem nächsten Schritt. Dadurch, dass die Pixel jeweils die Dünnschicht aus dem pyroelektrischen Material, bevorzugt Bleizirkonattitanat, aufweisen, ist die charakteristische S-Form der Signalausschläge bei der Annäherung des Teils und beim Entfernen des Teils erzeugt, wobei die S-Form zur Überprüfung dahingehend, ob die ausgeübte Translationsgeste von einer der vier Arten ist, mit herangezogen wird. Somit werden Signalausschläge, die etwa keine S-Form haben, so interpretiert, als dass keine Translationsgeste einer der vier Arten ausgeübt wurde. In überraschender Weise wird durch das Heranziehen der Form der Signalausschläge und die Überprüfung, ob die Signalausschläge die S-Form haben, eine übermäßige Steigerung der Präzision der Gestenerkennung erzielt.

Besonders bevorzugt ist es, dass das zeitliche Auftreten der Maxima und/oder Minima der S-förmigen Signalausschläge der Signale der Pixel für die Überprüfungen herangezogen werden. Die Maxima und/oder Minima der S-förmigen Signalausschläge der Signale sind von der Signalauswerteeinheit leicht und präzise bestimmbar. Dadurch ist es unter anderem ermöglicht mit der Schalterbetätigungseinrichtung und dem Verfahren zum Betreiben der Schalterbetätigungseinrichtung die Gestenerkennung für die nicht-taktilen Translationsgesten bereitzustellen, wobei die Schalterbetätigungseinrichtung eine derart miniaturisierte Bauweise bei günstigen Kosten und geringem Energieverbrauch hat, dass die Schalterbetätigungseinrichtung für das mobile Gerät besonders geeignet ist. Die Erkennung einer der vier Arten einer ausgeübten nicht-taktilen Translationsgeste mit dem mobilen Gerät ist hinreichend sicher und fehlerarm.

Im Folgenden wird eine bevorzugte Ausführungsform der Erfindung anhand der beigefügten schematischen Zeichnungen erläutert. Es zeigen:
Figur 1 eine schematische Darstellung einer erfindungsgemäßen Schalterbetätigungseinrichtung für ein erfindungsgemäßes mobiles Gerät,
Figur 2 eine schematische Darstellung eines Gestensensors,
Figur 3 ein Diagramm mit Amplitudenverläufen von Signalen des Gestensenors aus Figur 2,
Figur 4 ein Diagramm mit der ersten Ableitung nach der Zeit der Amplitudenverläufe aus Figur 3,
Figur 5 eine Detailansicht von Figur 3 und
Figur 6 ein Diagramm mit einer Vorschrift zur Bildung der ersten Ableitung nach der Zeit der Amplitudenverläufe, wie sie in Figur 4 gezeigt sind.

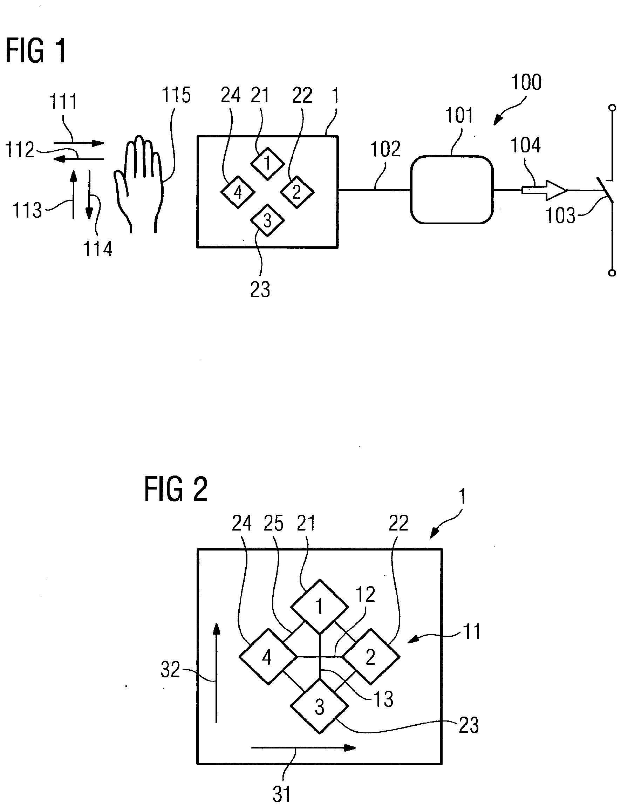

In Figur 1 ist eine Schalterbetätigungseinrichtung 100 gezeigt, die in ein mobiles Gerät eingebaut ist. Die Schalterbetätigungseinrichtung 100 weist einen Gestensensor 1 und eine Signalauswerteeinheit 101 auf, die via eine Signalleitung 102 zum Übertragen von Signalen vom Gestensensor 1 zur Signalauswerteeinheit 101 gekoppelt ist. Entsprechend der Auswertung der Signale, die vom Gestensensor 1 auf die Signalauswerteeinheit 101 übertragen werden, aktiviert oder deaktiviert die Signalauswerteeinheit 101 einen Aktuator 104, mit dem ein Schalter 103 des mobilen Geräts betätigbar ist. Der Schalter 103 ist zum Aktivieren/Deaktivieren einer Funktionalität des mobilen Geräts in diesem verschaltet.

Der Gestensensor 1 ist zum Detektieren von nicht-taktilen Translationsgesten vorgesehen, wobei, je nachdem welche Translationsgeste der Gestensensor 1 detektiert, ein Signal oder mehrere Signale via die Signalleitung 102 zur Signalauswerteeinheit 101 übertragen werden, aufgrund dessen die Betätigung des Schalters 103 via den Aktuator 104 bewerkstelligt ist. Die Betätigung des Schalters 103 wird nur dann ausgelöst, wenn vom Gestensensor 1 und von der Signalauswerteeinheit 101 eine von vier Arten an Translationsgesten 111 bis 114 identifiziert ist.

Die Translationsgesten sind mit einer Hand 115 in der Nähe des Gestensensors 1 nicht-taktil auszuüben, wobei vom Gestensensor 1 von der Hand 115 emittierte Wärme detektierbar ist. In Figur 1 gesehen ist die Translationsgeste erster Art 111 eine Bewegung der Hand 115 von links nach rechts, die Translationsgeste zweiter Art 112 eine Bewegung der Hand 115 von rechts nach links, die Translationsgeste dritter Art 113 eine Bewegung der Hand 115 von unten nach oben und die Translationsgeste vierter Art 115 eine Bewegung der Hand 115 von oben nach unten.

In Figur 2 ist eine schematische Darstellung des Gestensensors 1 gezeigt, der ein Rhombus 11 mit einer Längsdiagonale 12 und einer Querdiagonale 13 aufweist, wobei in jeder Ecke des Rhombus 11 jeweils ein Pixel 21 bis 24 angeordnet ist. In Figur 2 gesehen ist in der oberen Ecke des Rhombus 11 das erste Pixel 21, in der rechten Ecke des Rhombus 11 das zweite Pixel 22, in der unteren Ecke des Rhombus 11 das dritte Pixel 23 und in der linken Ecke des Rhombus 11 das vierte Pixel 24 angeordnet. Der Abstand 25 von zwei unmittelbar benachbarten Pixeln liegt zwischen 50 µm bis 300 µm. Eine Längsrichtung 31, die in Figur 2 waagerecht verläuft, ist parallel zur Längsdiagonale 12, die vom vierten Pixel 24 und vom zweiten Pixel 22 gebildet ist. Eine Querrichtung 32 ist in Figur 2 gesehen parallel zur Querdiagonale 13, die vom ersten Pixel 21 und vom dritten Pixel 23 gebildet ist. Die Translationsgesten erster Art 111 und zweiter Art 112 verlaufen parallel zur Längsrichtung 31, wohingegen die Translationsgesten dritter Art 113 und vierter Art 114 parallel zur Querrichtung 32 verlaufen, wobei die Translationsgesten erster Art 111 und zweiter Art 112 gegensätzliche Richtungen und die Translationsgesten dritter Art 113 und vierter Art 114 gegensätzliche Richtungen haben.

Die Pixel 21 bis 24 weisen jeweils einen Dünnfilm aus Bleizirkonattitanat auf, mit dem das Signal erzeugt wird, sobald das jeweilige Pixel 21 bis 24 von der Hand 115 emittierte Wärme detektiert. Somit wird beim Ausüben einer der Translationsgesten mit der Hand 115 von jedem Pixel 21 bis 24 das Signal mit einem Signalausschlag 58 entsprechend dem zeitlichen Intensitätsverlauf der vom Dünnfilm des entsprechenden Pixels 21 bis 24 detektierten Wärme an die Signalauswerteeinheit 101 ausgegeben. Das Signal des ersten Pixels 21 ist mit dem Bezugszeichen 51, das Signal des zweiten Pixels 22 ist mit dem Bezugszeichen 52, das Signal des dritten Pixels 23 ist mit dem Bezugszeichen 53 und das Signal des vierten Pixels 24 ist mit Bezugszeichen 54 bezeichnet. In Figur 3 ist ein Diagramm mit den zeitlichen Amplitudenverläufen der von den Pixeln 21 bis 24 ausgegebenen Signalen 51 bis 54 gezeigt, wobei über der Abszisse 61 die Zeit und über die Ordinate 62 die Amplitude aufgetragen sind. Die Signale 51 bis 54 weisen jeweils eine S-Form auf, wobei ein erster Teil 56 der S-Form des Signalausschlags bei einer Annäherung der Hand 115 an den Gestensensor 1 und ein auf dem ersten Teil 56 folgender zweiter Teil 57 der S-Form des Signalausschlags bei einer Entfernung der Hand 115 vom Gestensensor 1 erzeugt wird. Vor dem ersten Teil 56 der S-Form des Signalausschlags und nach dem zweiten Teil 57 der S-Form des Signalausschlags stellt sich ein Signalniveau 55 bei Pixelpassivität ein, die eintritt, wenn keine von der Hand 115 emittierte Wärme von dem Gestensensor 1 detektiert wird.

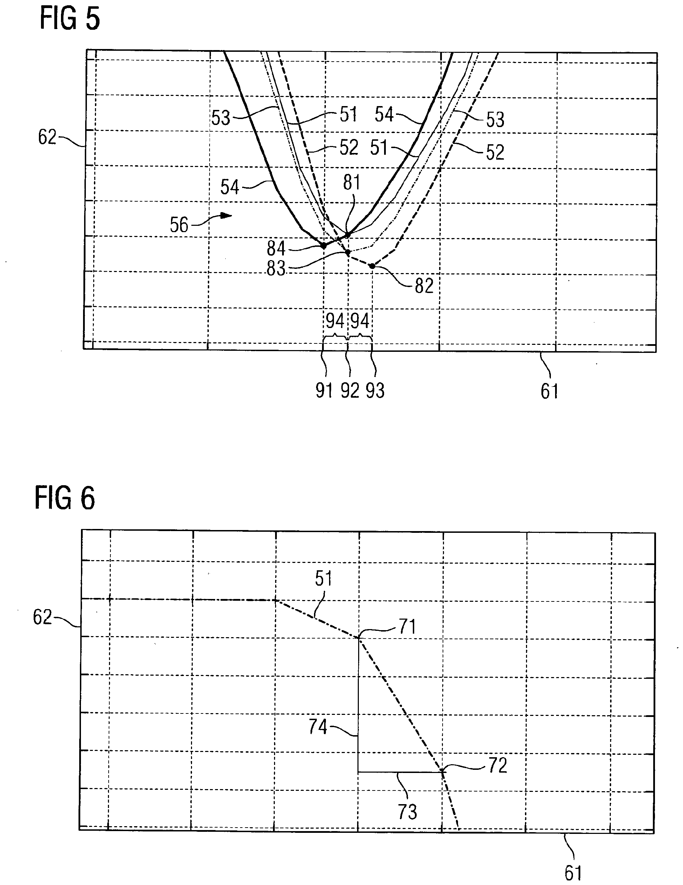

Alternativ zur Figur 3 ist in Figur 4 über die Ordinate 63 die erste Ableitung nach der Zeit der in Figur 3 aufgetragenen Amplitudenverläufe dargestellt. In Figur 6 ist ein repräsentativer Ausschnitt eines der Signale 51 bis 54 gezeigt, wobei die Amplitude dieses Signals über die Zeit aufgetragen ist. Der Amplitudenverlauf ist insbesondere von einem ersten Stützpunkt 71 und einem zweiten Stützpunkt 72 gebildet, wobei die Stützpunkte 71 und 72 durch ein Zeitinkrement 73 zueinander zeitlich versetzt sind und zwischen den Stützpunkten 71 und 72 eine Amplitudendifferenz 74 ausgebildet ist. Die zeitliche Ableitung nach der Zeit ist diskret mit einem Quotienten aus der Amplitudendifferenz 74 und dem Zeitinkrement 73 zu bilden.

In Figur 5 ist ein Detail aus Figur 3 gezeigt, wobei der erste Teil 56 der S-Form des Signalausschlags bei Annäherung vergrößert dargestellt ist. Es sind die Verläufe der Amplituden der Signale 51 bis 54 gezeigt, wobei jeder der Amplitudenverläufe jeweils ein Minimum 81 bis 84 aufweist. Die Signale 51 bis 54 sind durch die Translationsgeste der ersten Art 111 erzeugt. Beim Ausüben der Translationsgeste der ersten Art 111 wird von der Hand 115 zuerst das vierte Pixel 24, dann gleichzeitig das erste Pixel 21 und das dritte Pixel 23 und sodann das zweite Pixel 22 passiert. Dadurch ergibt sich ein entsprechender zeitlicher Versatz der Signale 51 bis 54, so dass das Signal 54 des vierten Pixels 24 das zeitlich erste Signal und das Signal 52 des zweiten Pixels 22 das zeitlich letzte Signal sind. Die Signale 52 und 53 des zweiten Pixels 22 und des dritten Pixels 23 liegen zeitlich zwischen den Signalen 51 und 54. Diese zeitliche Anordnungsreihenfolge der Signale 51 bis 54 spiegelt sich auch in der Anordnung der Minima 81 bis 84 wider, so dass das vierte Minimum 84 als erstes und das zweite Minimum 82 als letztes auftritt, wobei das erste Minimum 81 und das dritte Minimum 83 zwischen den Minima 84 und 82 liegen.

Die Translationsgeste der ersten Art 111 wird so ausgeführt, dass die Hand 115 parallel zur Längsrichtung 31 und senkrecht zur Querrichtung 32 bewegt wird. Dadurch wird die Hand 115 zuerst vom vierten Pixel 24 und zuletzt vom zweiten Pixel 22 detektiert, wobei die Detektion der Hand 115 vom dritten Pixel 23 und ersten Pixel 21 dazwischen liegt. Dadurch, dass die Translationsgeste der ersten Art 111 senkrecht zur Querrichtung 32 verläuft, detektieren das erste Pixel 21 und das dritte Pixel 23 die Hand 115 gleichzeitig, so dass die Signale 51 und 53 im Wesentlichen übereinander liegen und die dazugehörigen Minima 81 und 83 im Wesentlichen zeitgleich auftreten. Das Auftreten des vierten Minimums 84 ist in Figur 5 mit einem ersten Zeitpunkt 91 bezeichnet, das Auftreten des ersten Minimums 81 bzw. des dritten Minimums 83 mit einem zweiten Zeitpunkt 92 und das Auftreten des zweiten Minimums 82 mit einem dritten Zeitpunkt 93. Zwischen dem ersten Zeitpunkt 91 und dem zweiten Zeitpunkt 92 sowie zwischen dem zweiten Zeitpunkt 92 und dem dritten Zeitpunkt 93 liegt jeweils ein Zeitversatz 94.

Bei der Betätigung der Schalterbetätigungseinrichtung 100 können von der Hand 115 beliebige Gesten ausgeübt werden. Jedoch ist es so vorgesehen, dass nur beim Ausüben einer Translationsgeste einer der vierten Arten 111 bis 114 der Schalter 103 entsprechend der Art 111 bis 114 der Translationsgeste betätigt werden soll. Somit gilt es aus einer Vielzahl an möglichen Translationsgesten und Störungseinflüssen aus der Umgebung der Schalterbetätigungseinrichtung 100 das Vorhandensein einer Translationsgeste einer der vier Arten 111 bis 114 zu identifizieren.

Zur Identifikation der ausgeübten Translationsgeste werden die Signale 51 bis 54 von dem Gestensensor 1 auf die Signalauswerteeinheit 101 übertragen. In der Signalauswerteeinheit 101 wird überprüft, ob die Signale 51 bis 54 eine S-Form haben und im zeitlichen Verlauf zuerst ein Amplitudenausschlag nach unten und dann nach oben vorliegt, das heißt ob zuerst die Minima 81 bis 84 der Signale 51 bis 54 und dann ihre Maxima auftreten. Fällt diese Überprüfung positiv aus, werden die Signale 51 bis 54 für die Identifizierung der Translationsgeste herangezogen. Denkbar wäre auch, dass die Pixel 21 bis 24 derart verschaltet sind, dass beim Ausüben derselben Translationsgeste zuerst die Maxima und dann die Minima auftreten. Zusätzlich wird in der Signalauswerteeinheit 101 überprüft, ob die Absolutwerte aller vier Minima 81 bis 84 des ersten Teils 56 der S-Form des Signalausschlags bei Annäherung der Hand 115 und der vier Maxima des zweiten Teils 56 der S-Form des Signalausschlags bei Entfernung der Hand 115 über einem vorherbestimmten Amplitudenniveau liegen. Das vorherbestimmte Amplitudenniveau ist derart bemessen, dass erwartete Störsignale aus der Umgebung des Gestensensors 1 unter dem vorherbestimmten Amplitudenniveau liegen.

Der Abstand zwischen zwei der Pixel 21 bis 24, die unmittelbar benachbart angeordnet sind, liegt zwischen 50 µm bis 300 µm. Aufgrund der üblichen Bewegungsgeschwindigkeiten der Hand 115 ist mit der zeitlichen Abfolge der Minima 81 bis 84 bzw. ihrer zugehörigen Maxima die Identifikation der Art 111 bis 114 der Translationsgeste bzw. ein Verwerfen der Translationsgeste als nicht zu einer der Arten 111 bis 114 gehörend möglich. Das Funktionieren der Signalauswerteeinheit 101 wird im Folgenden anhand der Identifikation der Translationsgeste der ersten Art 111 erläutert. Die Identifikationen der Translationsgesten der anderen Arten 112 bis 114 erfolgt analog.

In der Signalauswerteeinheit 101 wird überprüft, ob der zeitliche Versatz des Minimums 81 des ersten Pixels 21 und des Minimums 83 des dritten Pixels 23 oder der zeitliche Versatz des Minumums 82 des zweiten Pixels 22 und des Minimums 84 des vierten Pixels 24 innerhalb einer Zeitspanne von 0,5 ms liegen. Trifft dies für keine der Pixelpaare 21, 23 und 22, 24 zu, ist das von dem Gestensensor 1 detektierte Signal als nicht zu einer Translationsgeste einer der vier Arten 111 bis 114 gehörend zu verwerfen. Wird beispielsweise in der Signalauswerteeinheit 101 ermittelt, dass das erste Minimum 81 des ersten Pixels 21 und das dritte Minimum 83 des dritten Pixels 23 innerhalb von 0,5 ms auftreten, so wird daraus abgeleitet, dass entweder eine Translationsgeste der ersten Art 111 oder eine Translationsgeste der zweiten Art 112 vorliegt. Sodann wird in der Signalauswerteeinheit 101 überprüft, ob das vierte Minimum 84 des vierten Pixels 24 vor bzw. nach den Minima 81 und 83 der Pixel 21 und 23 bzw. danach und das zweite Minimum 82 des zweiten Pixels 22 nach den Minima 81 und 83 der Pixel 21 und 23 oder davor liegt.

Ergibt die Überprüfung in der Signalauswerteeinheit 101, dass das vierte Minimum 84 um 7 ms bis 40 ms vor dem ersten Minimum 81 oder dem dritten Minimum 83, je nachdem, welches der Minima 81, 83 früher auftritt, und das zweite Minimum 82 um 7 ms bis 40 ms nach dem ersten Minimum 81 oder dem dritten Minimum 83, je nachdem welches der Minima 81, 83 später auftritt, wird die vom Gestensensor 1 detektierte Translationsgeste als eine Translationsgeste der ersten Art 111 identifiziert. Dementsprechend, wie es in der Signalauswerteeinheit 101 hinterlegt ist, wird via den Aktuator 104 der Schalter 103 betätigt. Gesten, die nicht als zu einer der vier Arten 111 bis 114 zugehörig identifiziert werden, werden in der Signalauswerteeinheit 101 verworfen und führen zu keiner Betätigung des Schalters 103. Die Identifikation einer Translationsgeste der zweiten bis vierten Art 112 bis 114 erfolgt in analoger Art und Weise. Grundsätzlich ist jede beliebige Kombination an den Überprüfungen in jeder beliebigen Reihenfolge denkbar.

### Bezugszeichenliste

1 Gestensensor
11 Rhombus
12 Längsdiagonale
13 Querdiagonale
21 erstes Pixel
22 zweites Pixel
23 drittes Pixel
24 viertes Pixel
25 Abstand von zwei benachbarten Pixel
31 Längssrichtung
32 Querrichtung
51 Signal des ersten Pixels
52 Signal des zweiten Pixels
53 Signal des dritten Pixels
54 Signal des vierten Pixels
55 Signalniveau bei Pixelpassivität
56 erster Teil der S-Form des Signalausschlags bei Annäherung
57 zweiter Teil der S-Form des Signalausschlags bei Entfernung
58 Signalausschlag
61 Abszisse: Zeit
62 Ordinate: Amplitude
63 Ordinate: erste Ableitung nach der Zeit der Amplitude
71 erster Stützpunkt
72 zweiter Stützpunkt
73 Zeitinkrement
74 Amplitudendifferenz
81 erstes Minimum
82 zweites Minimum
83 drittes Minimum
84 viertes Minimum
91 erster Zeitpunkt
92 zweiter Zeitpunkt
93 dritter Zeitpunkt
94 Zeitversatz
100 Schalterbetätigungseinrichtung
101 Signalauswerteeinheit
102 Signalleitung
103 Schalter
104 Aktuator
111 Translationsgeste erster Art
112 Translationsgeste zweiter Art
113 Translationsgeste dritter Art
114 Translationsgeste vierter Art
115 Hand

## Patentansprüche

1. Schalterbetätigungseinrichtung (100) zum Betätigen eines Schalters (103) durch vier mögliche Arten (111 bis 114) von nicht-taktilen Translationsgesten, die mit einem Wärme emittierenden Teil (115) auszuüben sind, mit einem Gestensensor (1), der eingerichtet ist beim Ausüben einer der Arten (111 bis 114) der Translationsgesten vom Teil (115) emittierte Wärme mittels mindestens vier nebeneinander angeordneter Pixel (21 bis 24) zu detektieren und pro Pixel (21 bis 24), die jeweils einen Dünnfilm aus pyroelektrischem Material aufweisen, ein Signal (51 bis 54) mit einem Signalausschlag (58) entsprechend dem zeitlichen Intensitätsverlauf der vom Dünnfilm des entsprechenden Pixels (21, 22, 23, 24) detektierten Wärme auszugeben, mit einem Aktuator (104), der dazu eingerichtet ist den Schalter anzusteuern und mit einer Signalauswerteeinheit (101), die dazu eingerichtet ist aus dem zeitlichen Aufeinanderfolgen der Signalausschläge (58) die Ausübung einer der Arten (111 bis 114) der Translationsgesten zu ermitteln und den Aktuator (104) zur Betätigung des Schalters anzusteuern sobald die Ausübung einer der Arten (111 bis 114) der Translationsgesten ermittelt ist, wobei eine erste Art (111) der Translationsgesten durch eine Bewegung des Teils (115) in eine Längsrichtung (31), eine zweite Art (112) der Translationsgesten durch eine Bewegung des Teils (115) entgegen der Längsrichtung (31), eine dritte Art (113) der Translationsgesten durch eine Bewegung des Teils (115) in eine von der Längsrichtung (31) abweichende Querrichtung (32) und eine vierte Art (114) der Translationsgesten durch eine Bewegung des Teils (115) entgegen der Querrichtung (32) definiert ist und vier der Pixel (21 bis 24) jeweils in einer der Ecken eines konvexen Vierecks (11) angeordnet sind, dessen eine der Diagonalen (12) im wesentlichen parallel zur Längsrichtung (31) und die andere Diagonale (13) im wesentlichen parallel zur Querrichtung (32) sind.

2. Schalterbetätigungseinrichtung gemäß Anspruch 1, wobei das pyroelektrische Material Bleizirkonattitanat ist.

3. Schalterbetätigungseinrichtung gemäß Anspruch 1 oder 2, wobei das Viereck ein Rhombus (11) ist.

4. Schalterbetätigungseinrichtung gemäß einem der Ansprüche 1 bis 3, wobei der Abstand (25) von zwei unmittelbar benachbarten Pixel (21 bis 24) zwischen 50 µm bis 300 µm liegt.

5. Schalterbetätigungseinrichtung gemäß einem der Ansprüche 1 bis 4, wobei das Teil eine menschliche Hand (115) und die vom Teil emittierte Wärme die von der menschlichen Hand (115) abgestrahlte Körperwärme ist.

6. Mobiles Gerät mit der Schalterbetätigungseinrichtung (100) gemäß einem der Ansprüche 1 bis 5, wobei der Schalter (103) zum Aktivieren / Deaktivieren einer Funktionalität des mobilen Geräts in diesem verschaltet ist.

7. Verfahren zum Betreiben einer Schalterbetätigungseinrichtung (100) gemäß einem der Ansprüche 1 bis 5, mit den Schritten:
- Ausgeben von den Pixeln (21 bis 24) die Aufeinanderfolge der Signalausschläge (58) an die Signalauswerteeinheit (101), indem eine der Arten (111) der möglichen Translationsgesten mit dem Wärme emittierenden Teil (115) ausgeübt wird;
- Anhand der Aufeinanderfolge der Signalausschläge (58): Identifizieren des zuerst angesprochenen Pixels (24) und des zuletzt angesprochenen Pixels (22);
- Überprüfen, ob die Signalausschläge (58) der beiden anderen Pixel (21, 23) zeitlich zwischen den Signalausschlägen (58) des zuerst angesprochenen Pixels (24) und des zuletzt angesprochenen Pixels (22) liegen; Ist die Überprüfung positiv, Fortfahren mit dem nächsten Schritt;
- Zuordnen der vom zuerst angesprochenen Pixel (24) und zuletzt angesprochenen Pixel (22) gebildeten Diagonale (12) zur Längsrichtung (31) oder zur Querrichtung (32), je nach dem zu welcher Richtung (31, 32) die Diagonale (13) paralleler ist, und Berücksichtigen der Ansprechreihenfolge vom zuerst angesprochenen Pixel (24) und zuletzt angesprochenen Pixel (22), so dass die Art (111) der ausgeübten Translationsgeste als die erste (111), die zweite (112), die dritte (113) oder die vierte Art (114) identifiziert wird;
- Je nach identifizierter Art (111) der Translationsgeste: Entsprechendes Ansteuern des Aktuators (104) zum Betätigen des Schalters (103) durch die Signalauswerteeinheit (101).

8. Verfahren gemäß Anspruch 7, mit dem Schritt:
- Überprüfen, ob die Absolutwerte aller vier Signalausschläge (58) über einem vorherbestimmten Niveau liegen; Ist die Überprüfung positiv, Fortfahren mit dem nächsten Schritt.

9. Verfahren gemäß Anspruch 7 oder 8, mit dem Schritt:
- Überprüfen, ob der zeitliche Versatz derjenigen Signalausschläge, die zeitlich zwischen den Signalausschlägen des zuerst angesprochenen Pixels (24) und des zuletzt angesprochenen Pixels (22) liegen, innerhalb einer ersten vorherbestimmten Versatzzeitspanne liegt; Ist die Überprüfung positiv, Fortfahren mit dem nächsten Schritt.

10. Verfahren gemäß Anspruch 9, wobei die erste vorherbestimmte Versatzzeitspanne 0,5 ms beträgt.

11. Verfahren gemäß einem der Ansprüche 7 bis 10, mit dem Schritt:
- Überprüfen, ob der zeitlich erste Signalausschlag mindestens um eine zweite vorherbestimmte Versatzzeitspanne vor dem zeitlich zweiten oder dritten Signalausschlag und der zeitlich vierte Signalausschlag mindestens um die zweite vorherbestimmte Versatzzeitspanne nach dem zeitlich zweiten oder dritten Signalausschlag liegen; Ist die Überprüfung positiv, Fortfahren mit dem nächsten Schritt.

12. Verfahren gemäß Anspruch 11, wobei die zweite vorherbestimmte Versatzzeitspanne zwischen 7 ms und 40 ms liegt.

13. Verfahren gemäß einem der Ansprüche 7 bis 12, wobei für die Signalausschläge (58) die Amplitudenverläufe der von den Pixel (21 bis 24) ausgegeben Signale (51 bis 54) oder die erste Ableitung nach der Zeit der Amplitudenverläufe der von den Pixel ausgegeben Signale (51 bis 54) verwendet werden.

14. Verfahren gemäß einem der Ansprüche 7 bis 13, wobei die Pixel (21 bis 24) die Dünnschicht aus dem pyroelektrischen Material aufweisen, mit dem durch das Annähern des Teils (115) an jedes Pixel (21 bis 24) und das Entfernen des Teils (115) von jedem Pixel (21 bis 24) der jeweilige Signalausschlag (58) in S-Form (56, 57) einhergeht, mit dem Schritt:
a1) Identifizieren der Formen der Signalausschläge und Überprüfen, ob die Formen der Signalausschläge jeweils die S-Form (56, 57) haben; Ist die Überprüfung positiv, Fortfahren mit dem nächsten Schritt.

15. Verfahren gemäß Anspruch 14, wobei das zeitliche Auftreten der Minima und/oder der Maxima der S-förmigen (56, 57) Signalausschläge (58) der Signale (51 bis 54) der Pixel (51 bis 54) für die Überprüfungen herangezogen werden.

## Claims

1. Switch operating device (100) for operating a switch (103) by four possible types (111 to 114) of non-tactile translation gestures that are to be performed with a part (115) emitting heat, wherein the switch operation device (100) comprises a gesture sensor (1) that is adapted to detect heat emitted by the part (115) during performing one of the types (111 to 114) of the translation gestures by means of at least four pixels (21 to 24) that are arranged next to each other and to output a signal (51 to 54) per pixel (21 to 24), wherein each of the pixels (21 to 24) comprises a thin film out of pyroelectric sensitive material, wherein the signal (51 to 54) has a signal deflection (58) corresponding to the temporal intensity curve of the heat detected by the thin film of the corresponding pixel (21, 22, 23, 24), wherein the signal operation device (100) comprises an actuator (104) that is adapted to control the switch, and wherein the signal operating device (100) comprises a signal processing unit (101) that is adapted to determine the performance of one of the types (111 to 114) of the translation gestures out of the temporal succession of the signal deflections (58) and to control the actuator (104) for operating the switch as soon as the performance of one of the types (111 to 114) of the translation gestures is determined, wherein a fist type (111) of the translation gestures is defined by a movement of the part (115) in a longitudinal direction (31), a second type (112) of the translation gestures is defined by a movement of the part (115) against the longitudinal direction (31), a third type (113) of the translation gestures is defined by a movement of the part (115) in a transverse direction (32) deviating from the longitudinal direction (31) and a fourth type (114) of the translation gestures is defined by a movement of the part (115) against the transverse direction (32), and wherein four of the pixels (21 to 24) are respectively arranged in one of the corners of a convex tetragon (11), wherein one of the diagonals (12) of the tetragon (11) is substantially parallel to the longitudinal direction (31) and the other diagonal (13) of the tetragon (11) is substantially parallel to the transverse direction (32).

2. Switch operating device according to claim 1, wherein the pyroelectric material is lead-zirconate-titanate.

3. Switch operating device according to claim 1 or 2, wherein the tetragon is a rhombus (11).

4. Switch operating device according to any one of the claims 1 to 3, wherein the distance (25) of two immediately adjacent pixels (21 to 24) is between 50 µm and 300 µm.

5. Switch operating device according to any one of the claims 1 to 4, wherein the part is a human hand (115) and the heat emitted from the part is the body heat radiated by the human hand (115).

6. Mobile device comprising the switch operating device (100) according to any one of the claims 1 to 5, wherein the switch (103) is interconnected in the mobile device to activate / deactivate a functionality of the mobile device.

7. Method for operating a switch operating device according to any one of the claims 1 to 5, wherein the method comprises the steps:
- outputting the succession of the signal deflections (58) from the pixels (21 to 24) to the signal processing unit (101) in response to performance of one of the types (111) of the possible translation gestures with the part (115) emitting heat;
- Based on the succession of the signal deflections (58): identifying of the temporally first addressed pixel (24) and of the temporally last addressed pixel (22);
- verifying if the signal deflections (58) of the both other pixels (21, 23) are temporally between the signal deflections (58) of the temporally first addressed pixel (24) and of the temporally last addressed pixel (22); If the verification is positive, proceeding with the next step;
- assigning the diagonal (12) that is formed by the temporally first addressed pixel (24) and the temporally last addressed pixel (22) to the longitudinal direction (31) or to the transverse direction (32) according to which of the directions (31, 32) the diagonal (13) is more parallel to and taking into account the succession of the addressing order of the temporally first addressed pixel (24) and of the temporally last addressed pixel (22), so that the type (111) of the performed translation gestures is identified as the first (111), the second (112), the third (113) or fourth type (114);
- according to the identified type (111) of the translation gesture:
controlling of the actuator (104) respectively to operate the switch (103) by the signal processing unit (101).

8. Method according to claim 7, wherein the method comprises the step:
- verifying if the absolute values of all four signal deflections (58) are above a predetermined level; If the verification is positive, proceeding with the next step.

9. Method according to claim 7 or 8, wherein the method comprises the step:
- verifying if the temporally delay of the signal deflections that are temporally between the signal deflections of the temporally first addressed pixel (24) and of the temporally last addressed pixel (22) is within a first predetermined delay duration; If the verification is positive, proceeding with the next step.

10. Method according to claim 9, wherein the first predetermined delay duration is 0,5 ms.

11. Method according to any one of the claims 7 to 10, wherein the method comprises the step:
- verifying if the temporally fist signal deflection is of at least a second predetermined delay duration temporally before the temporally second or third signal deflection und if the temporally fourth signal deflection is of at least the second predetermined delay duration temporally after the second or third signal deflection; If the verification is positive, proceeding with the next step.

12. Method according to claim 11, wherein the second predetermined delay duration is between 7 ms and 40 ms.

13. Method according to any one of the claims 7 to 12, wherein the amplitude curves of the signals (51 to 54) that are outputted by the pixels (21 to 24) or the first derivative with respect to time of the amplitude curves of the signals (51 to 54) that are outputted by the pixels are used for the signal deflections (58).

14. Method according to any one of the claims 7 to 13, wherein the pixels (21 to 24) comprise the thin film made from the pyroelectric sensitive material with which the approach of the part (115) to each pixel (21 to 24) and the withdrawal of the part (115) from each pixel (21 to 24) involve the respective signal deflection (58) in S-shape (54, 57), wherein the method comprises the step:
a1) identifying the shapes of the signal deflections and verifying if the shapes of the signal deflections have respectively the S-shape (56, 57); If the verification is positive, proceeding with the next step.

15. Method according to claim 14, wherein the temporal occurrence of the minima and/or maxima of the S-shaped (56, 57) signal deflections (58) of the signals (51 to 54) of the pixels (51 to 54) are used for the verification.

## Revendications

1. Dispositif d'actionnement de commutateur (100) pour actionner un commutateur (103) par quatre types possibles (111 à 114) de gestes de translation non tactiles, qui doivent être effectués avec une partie (115) émettant de la chaleur, comportant un capteur de geste (1) adapté pour détecter, au moyen d'au moins quatre pixels (21 à 24) disposés les uns à côté des autres, de la chaleur émise par la partie (115) lorsqu'un des types (111 à 114) de gestes de translation est effectué, et pour délivrer, pour chaque pixel (21 à 24) comportant respectivement un film mince en matériau pyroélectrique, un signal (51 à 54) avec une déviation de signal (58) correspondant à la variation d'intensité dans le temps de la chaleur détectée par le film mince du pixel (21, 22, 23, 24) correspondant, comportant un actionneur (104) adapté pour commander le commutateur ainsi qu'une unité d'analyse de signaux (101) adaptée pour déterminer à partir des séquences temporelles des déviations de signaux (58) que l'un des types (111 à 114) de gestes de translation est effectué et pour commander à l'actionneur (104) d'actionner le commutateur dès que l'exécution de l'un des types (111 à 114) de gestes de translation est déterminée, un premier type de geste (111) parmi les gestes de translation étant défini par un déplacement de la partie (115) dans une direction longitudinale (31), un deuxième type de geste (112) parmi les gestes de translation étant défini par un déplacement de la partie (115) à l'opposé de la direction longitudinale (31), un troisième type de geste (113) parmi les gestes de translation étant défini par un déplacement de la partie (115) dans une direction transversale (32) différente de la direction longitudinale (31), et un quatrième type de geste (114) parmi les gestes de translation étant défini par un déplacement de la partie (115) à l'opposé de la direction transversale (32), et quatre des pixels (21 à 24) étant respectivement disposés dans l'un des coins d'un quadrilatère convexe (111), dont l'une des diagonales (12) est sensiblement parallèle à la direction longitudinale (31) et l'autre diagonale (13) est sensiblement parallèle à la direction transversale (32).

2. Dispositif d'actionnement de commutateur selon la revendication 1, dans lequel le matériau pyroélectrique est le zirconate-titanate de plomb.

3. Dispositif d'actionnement de commutateur selon la revendication 1 ou la revendication 2, dans lequel le quadrilatère est un losange (11).

4. Dispositif d'actionnement du commutateur selon l'une des revendications 1 à 3, dans lequel la distance (25) entre deux pixels (21 à 24) immédiatement contigus est comprise entre 50 µm et 300 µm.

5. Dispositif d'actionnement de commutateur selon l'une des revendications 1 à 4, dans lequel la partie est une main humaine (115) et la chaleur émise par la partie est la chaleur corporelle émise par la main humaine (115).

6. Appareil mobile muni d'un dispositif d'actionnement de commutateur (100) selon l'une des revendications 1 à 5, dans lequel le commutateur (103) est connecté dans l'appareil mobile pour activer/désactiver une fonctionnalité de ce dernier.

7. Procédé pour faire fonctionner un dispositif d'actionnement de commutateur (100) selon l'une des revendications 1 à 5, comportant les étapes consistant à :
- générer, à partir des pixels (21 à 24), la séquence des déviations de signaux (58) sur l'unité d'analyse de signal (101), en effectuant l'un des types (111) de gestes de translation possibles avec la partie (115) émettant de la chaleur,
- au moyen de la séquence des déviations de signaux (58) : identifier le pixel activé en premier (24) et le pixel activé en dernier (22),
- vérifier que les déviations de signaux (58) des deux autres pixels (21, 23) se situent temporellement entre les déviations de signaux (58) du pixel activé en premier (24) et du pixel activé en dernier (22), si le contrôlé est positif, passer à l'étape suivante,
- attribuer la diagonale (12) formée par le pixel activé en premier (24) et le pixel activé en dernier (22) à la direction longitudinale (31) ou à la direction transversale (32), selon la direction (31, 32) à laquelle la diagonale (13) est parallèle, et tenir compte de la séquence d'activation du pixel activé en premier (24) et du pixel activé en dernier (22), de sorte que le type (111) du geste de translation effectué est identifié comme étant le premier (111), le deuxième (112), le troisième (113) ou le quatrième (114) type de geste,
- selon le type (111) de geste de translation identifié: commander en conséquence l'actionneur (104) de manière à actionner le commutateur (103) par le biais de l'unité d'analyse de signaux (101).

8. Procédé selon la revendication 7, comportant l'étape consistant à :
- vérifier que les valeurs absolues de la totalité des quatre déviations de signaux (58) sont supérieures à un niveau prédéfini ; si le contrôle est positif, passer à l'étape suivante.

9. Procédé selon la revendication 7 ou 8, comportant l'étape consistant à :
- vérifier que le décalage dans le temps de chacune des déviations de signaux, qui se situent temporellement entre les déviations de signaux du pixel activé en premier (24) et du pixel activé en dernier (22), est à l'intérieur d'un premier intervalle de temps de décalage prédéfini ; si le contrôlé est positif, passer à l'étape suivante.

10. Procédé selon la revendication 9, dans lequel le premier intervalle de temps de décalage prédéfini est de 0,5 ms.

11. Procédé selon l'une des revendications 7 à 10, comportant l'étape consistant à :
- vérifier que la première déviation de signal dans le temps se situe au moins autour d'un second intervalle de temps de décalage prédéfini avant la deuxième ou troisième déviation de signal dans le temps et que la quatrième déviation de signal dans le temps se situe au moins autour du second intervalle de temps de décalage prédéfini après la deuxième ou troisième déviation de signal dans le temps, si le contrôlé est positif, passer à l'étape suivante.

12. Procédé selon la revendication 11, dans lequel le second intervalle de temps de décalage prédéfini est compris entre 7 ms et 40 ms.

13. Procédé selon l'une des revendications 7 à 12, dans lequel pour les déviations de signaux (58), les variations d'amplitude des signaux (51 à 54) délivrés par les pixels (21 à 24) ou la première dérivée après la durée des variations d'amplitude des signaux (51 à 54) délivrés par les pixels, sont utilisées.

14. Procédé selon l'une des revendications 7 à 13, dans lequel les pixels (21 à 24) comportent la couche mince constituée du matériau pyroélectrique, la déviation de signal (58) respective en forme de S (56, 57) étant liée au rapprochement de la partie (115) de chaque pixel (21 à 24) et à l'éloignement de la partie (115) de chaque pixel (21 à 24), comportant l'étape consistant à :
a1) identifier les formes des déviations de signaux et vérifier que les formes des déviations de signaux ont respectivement la forme en S (56, 57) ; si la vérification est positive, passer à l'étape suivante.

15. Procédé selon la revendication 14, dans lequel l'occurrence temporelle des minima et/ou des maxima des déviations de signaux (58) en forme de S (56, 57) des signaux (51 à 54) des pixels (51 à 54) a été déterminée pour les contrôles.
